## Europäisches Patentamt

## European Patent Office

## Office européen des brevets

(11) Numéro de publication: **0 133 125**

**B1**

(12) **FASCICULE DE BREVET EUROPÉEN**

(51) Int. Cl.⁴: **H 01 L 23/56**

(45) Date de publication du fascicule du brevet:
16.12.87

(21) Numéro de dépôt: **84401554.5**

(22) Date de dépôt: **24.07.84**

(54) Boîtier de composant électronique muni d'un condensateur.

(30) Priorité: **29.07.83 FR 8312542**

(43) Date de publication de la demande:
**13.02.85 Bulletin 85/7**

(45) Mention de la délivrance du brevet:
**16.12.87 Bulletin 87/51**

(84) Etats contractants désignés:
**DE GB SE**

(56) Documents cité:
**FR-A-2 529 386**
**GB-A-2 091 035**
**US-A-4 249 196**

**PATENTS ABSTRACTS OF JAPAN, vol. 6, no. 6(E-89)(884), 14 janvier 1982**

(73) Titulaire: **CIMSA SINTRA, 26, rue Malakoff, F-92600 Asnieres (FR)**

(72) Inventeur: **Val, Christian, THOMSON- CSF SCPI 173, bld Haussmann, F-75379 Paris Cedex 08 (FR)**

(74) Mandataire: **Benoit, Monique, THOMSON- CSF SCPI 19, avenue de Messine, F-75008 Paris (FR)**

## Description

L'invention a pour objet un boîtier constitué d'une embase portant un circuit ou un composant électronique, recouverte d'un capot, le boîtier comportant en outre un condensateur.

On désigne dans la présente description sous le terme général de "composant" tout composant passif ou actif, discret ou intégré, ainsi que tout circuit électronique (circuit hybride par exemple) susceptible d'être mis sous boîtier.

Ainsi qu'il est connu, il est fréquent qu'un composant ou circuit électronique nécessite un ou plusieurs condensateurs auxiliaires, notamment pour le découplage, qui ne peuvent pas être intégrés sur le même substrat que le composant considéré; ce ou ces condensateurs sont donc ajoutés sur la carte de circuit imprimé qui porte le composant et son boîtier, y occupant une surface importante par rapport à celle du composant, ce qui est en contradiction avec le souci d'augmentation de densité qui est de règle sur les matériels actuels.

Pour pallier cet inconvénient, il est connu par la demande de brevet français 2 456 388, au nom de THOMSON-CSF, d'utiliser l'embase du boîtier pour y réaliser un condensateur. A cet effet, on choisit une embase en céramique, qui constitue le diélectrique du condensateur, et on la recouvre des métallisations nécessaires pour constituer les armatures de ce condensateur. Toutefois, cette solution est peu adaptée à certaines applications, notamment celles qui utilisent des composants de puissance ou à haut degré d'intégration: en effet, l'embase d'un boîtier doit présenter des propriétés thermiques particulières, parmi lesquelles on peut citer un coefficient de dilatation thermique aussi proche que possible de celui du matériel semi-conducteur utilisé, le plus fréquemment le silicium ce qui conduit en général à choisir de l'alumine pour l'embase, ainsi qu'une bonne conduction thermique pour l'évacuation des calories. Ces différentes exigences ne sont pas forcément compatibles avec la réalisation d'un condensateur, principalement pour ce qui est de la constante diélectrique de l'embase et l'apparition de couplages parasites capacitifs entre les connexions du circuit et celles du condensateur.

Une deuxième structure a été proposée et décrite dans la demande de brevet français , au nom de CIMSA, dans laquelle l'embase présente une structure optimisée sur le plan thermique et la fonction capacitive est réalisée sur ou dans le capot du boîtier. Cette structure, si elle permet d'éviter les problèmes précédents, conduit toutefois dans certains cas à des difficultés de réalisation du fait que, lors de la fixation du capot sur l'embase, il est nécessaire de procéder à la fois au scellement du capot sur l'embase et à la réalisation des connexions électriques du condensateur avec le reste du circuit. En outre, ainsi qu'il est connu, les composants actuels tendent à traiter des signaux dont le potentiel est de plus en plus bas avec des temps de réponse de plus en plus courts: la conséquence en est que pour ces circuits, il est nécessaire de réduire au maximum l'impédance des interconnexions condensateur-composant qui, on le rappelle, est proportionnelle à la racine carrée du rapport L/C; à cette fin, il est nécessaire de réduire l'inductance L que présentent ces connexions, ce qui s'obtient notamment en réduisant leur longueur. Pour certaines applications, il peut être souhaitable de réduire encore cette impédance par rapport à ce qui est obtenu pour une structure du type de celle qui est décrite dans la demande de brevet 82-11402 précitée.

La présente invention a pour objet un boîtier comportant un condensateur, qui permette de répondre à ces divers impératifs grâce au fait que la fonction capacitive est réalisée par un composant discret, placé au-dessus du composant électronique, à l'intérieur de son boîtier.

Plus précisément, selon l'invention, un boîtier de composant électronique, comportant une embase sur laquelle est fixé le composant et un capot fixé sur l'embase, comporte en outre au moins un condensateur, placé entre le composant et le capot et connecté électriquement à l'embase.

D'autres objets, particularités et résultats de l'invention ressortiront de la description suivante, illustrée par les figures annexées qui représentent:
- la figure 1a, le schéma général d'un mode de réalisation, vu en coupe, du boîtier selon l'invention et la figure 1b, une vue en coupe partielle d'une autre partie de ce boîtier;
- les figures 2, a et b, respectivement une vue en coupe et une vue de dessus d'un mode de réalisation du condensateur placé dans le boîtier selon l'invention;
- les figures 3, a, b et c, trois variantes de réalisation du mode de connexion électrique du condensateur au boîtier selon l'invention.

Sur ces différentes figures, d'une part les mêmes références se rapportent aux mêmes éléments et, d'autre part, l'échelle réelle n'a pas été respectée pour la clarté de l'exposé.

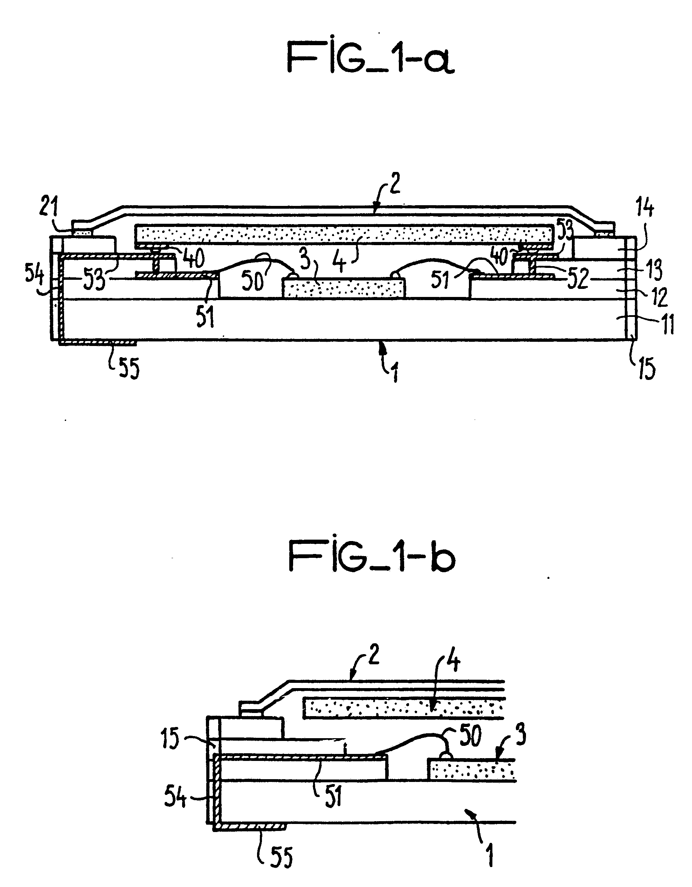

Sur la figure 1a, on a donc représenté un boîtier pour l'encapsulation d'un composant 3, par exemple un circuit électronique intégré réalisé sur une pastille de matériau semi-conducteur, par exemple de silicium. Ce boîtier se compose principalement d'une embase 1, portant le composant 3, d'un capot 2, fixé sur l'embase 1 de façon à enfermer le composant 3 hermétiquement, et d'un condensateur 4 placé dans le boîtier.

A titre d'exemple, on a représenté un boîtier d'un type particulier, connu sous le nom de "Chip Carrier" dans la littérature anglo-saxonne, qui présente la particularité d'être dépourvu de broches de connexion, celles-ci étant remplacées par de simples métallisations (55) sur la partie inférieure de l'embase 1.

L'embase 1 est réalisée en un matériau qui doit être rigide, de préférence isolant électrique et présentant certaines qualités thermiques, ainsi qu'il a été évoqué plus haut, à savoir principalement une bonne conduction thermique et un coefficient de dilatation aussi proche que possible de celui du composant 3; l'embase peut donc être par exemple en plastique, en verre, en céramique, etc...; dans le cas le plus fréquent en pratique où le composant 3 est en silicium, l'embase peut être avantageusement en alumine. L'embase se compose dans cet exemple de quatre parties distinctes, repérées respectivement 11, 12, 13 et 14. La première partie (11) est en forme de plaquette et supporte le composant 3 ; les trois autres parties sont constituées chacune d'un anneau, les anneaux étant concentriques et disposés l'un au-dessus de l'autre autour du composant 3, avec un diamètre intérieur croissant, de façon à permettre les connexions électriques entre le composant, le condensateur 4 et l'extérieur. Le composant 3 est fixé sur la face supérieure de la plaquette 11, par exemple par brasure sur une métallisation non représentée.

Les connexions sont réalisées de la façon suivante. Les points de connexion du composant 3 sont reliés chacun par des conducteurs, tels que 50, à des pistes conductrices 51 disposées sur la partie supérieure du premier anneau 12 de l'embase 1. Ces pistes 51 sont connectées au reste du dispositif de trois façons différentes selon la fonction qu'elles remplissent:

- dans une première façon, illustrée à titre d'exemple sur la partie gauche de la figure 1a, les pistes 51 aboutissent chacune à des puits conducteurs 52, traversant l'anneau 13 de part en part et réalisant les connexions électriques entre les pistes 51 et des pistes 53, portées par la surface supérieure de l'anneau 13; le condensateur 4 est muni de connexions 40 qui sont également connectées aux pistes 53 ; les pistes 53 aboutissent à des demi-trous 15, sensiblement en forme de demi-cylindres réalisés dans l'épaisseur de l'embase 1, à sa périphérie, dans lesquels des connexions repérées 54 les relient aux connexions 55 du boîtier ; ce premier mode de connexion a pour double fonction d'alimenter le condensateur 4 à partir de l'extérieur et de distribuer ensuite au composant 3 l'énergie stockée dans le condensateur;

- dans la deuxième façon, illustrée à titre d'exemple sur la partie droite de la figure 1a, les pistes 51 comme précédemment sont reliées aux connexions 40 du condensateur 4 par l'intermédiaire des puits 52 et des pistes 53 mais, ici, les pistes 53 ne sont pas reliées à l'extérieur du boîtier; ce mode de connexion a pour seule fonction la distribution au composant 3 de l'énergie stockée dans le condensateur 4;

- la troisième façon est illustrée sur la figure 1b, où on a représenté la fraction du boîtier intéressée par ces connexions; les pistes 51 ne sont pas ici reliées au condensateur 4 mais aboutissent sur les connexions 55 du boîtier par l'intermédiaire des connexions 54 et des demi-trous 15; ce mode de connexion a pour fonction la transmission des signaux, autres que les alimentations ($V_1$, $V_2$) et la masse, entre le composant et l'extérieur.

Les pistes et connexions 51 à 55 sont par exemple réalisées à base de métal réfractaire (tungstène par exemple).

Sur l'embase 1, il est connu de fixer un capot tel que 2, destiné à enfermer le circuit 3 de façon hermétique. Ce capot peut être métallique ou isolant, réalisé ou non dans le même matériau que l'embase 1. Il est fixé sur l'embase par l'intermédiaire d'un joint 21; dans le cas où embase et capot sont en céramique, le joint est par exemple un scellement verre ou un brasage.

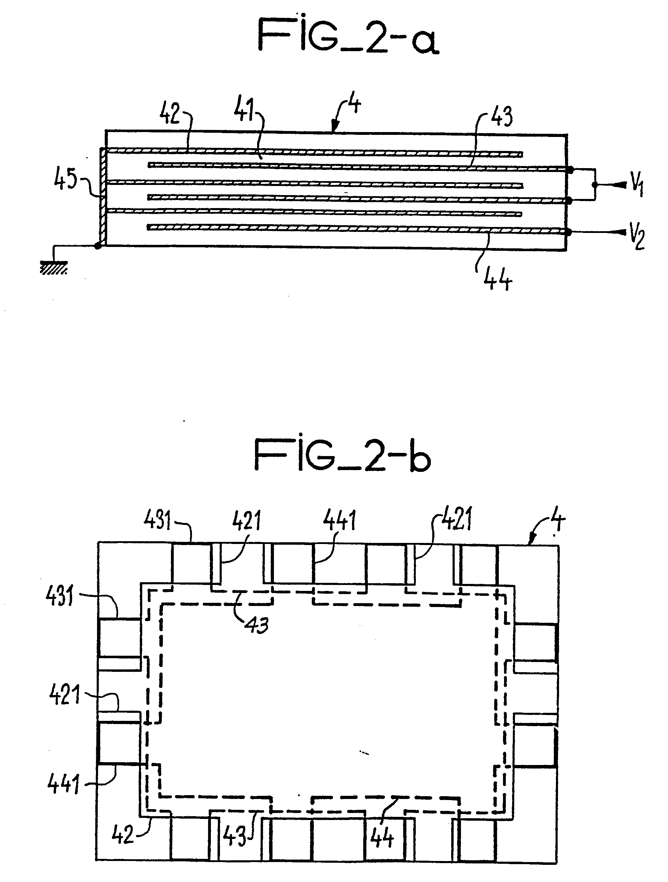

Les figures 2, a et b, représentent respectivement une vue en coupe et une vue de dessus d'un mode de réalisation du condensateur 4 de la figure 1.

Sur la figure 2a, on a donc représenté le condensateur 4 réalisé dans cet exemple selon la technologie connue des condensateurs multicouches, c'est-à-dire qu'on dispose alternativement des plaquettes diélectriques 41 à constante diélectrique élevée, par exemple constituées par un matériau diélectrique adapté aux hautes fréquences, du type I (classification NPO), et des métallisations formant armatures, repérées 42, 43 et 44, réalisées par exemple en argent-palladium, le condensateur 4 résultant étant par exemple sensiblement de forme parallélépipédique carré ou rectangle. A titre d'exemple, les métallisations de rangs impairs (à partir de la face supérieure du condensateur) sont repérées 42 et reliées par une connexion commune 45, déposée sur la partie latérale du condensateur 4, afin de les connecter à la masse; les connexions de rangs pairs sont reliées à un ou, comme dans l'exemple de la figure, plusieurs potentiels donnés, par exemple les électrodes 43 (au nombre de deux sur la figure) à un premier potentiel $V_1$ et une électrode 44 à un second potentiel $V_2$. On obtient de la sorte deux condensateurs.

Sur la figure 2b, on a représenté un exemple de disposition des différentes plaquettes de la figure 2a.

Sur cette figure, on voit que les métallisations de masse 42 sont de dimensions légèrement inférieures à celles du condensateur 4 et se prolongent par des languettes 421 vers la périphérie du condensateur. De la même façon, les métallisations 43, reliées au potentiel $V_1$ sont munies de languettes 431, placées aussi près que possible des languettes de masse 421 et en nombre égal. Enfin, les métallisations 44 reliées au second potentiel $V_2$ comportent également des languettes, repérées 441 et en nombre égal aux précédentes, de façon à former des groupes de trois languettes 421, 431, 441, en nombre aussi important que nécessaire à la distribution de l'énergie du condensateur 4 au composant 3.

On a ainsi réalisé une structure dans laquelle les connexions de masse et les deux potentiels $V_1$ et $V_2$ sont distribuées sur le pourtour du condensateur 4, permettant de réduire l'inductance des entrées-sorties puisque la connexion de masse est placée entre les connexions d'alimentation, aussi proche que possible les unes des autres.

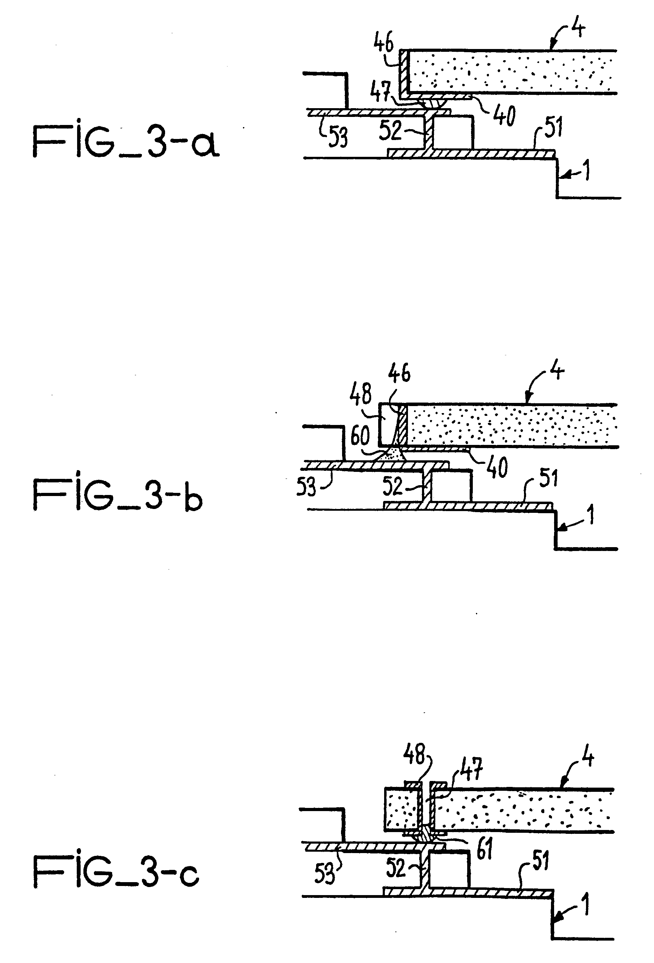

Les figures 3, a, b et c, représentent trois variantes de réalisation de la connexion électrique du condensateur 4 avec la piste 53 de l'embase 1 du boîtier selon l'invention.

Sur la figure 3a, on a donc représenté une extrémité du condensateur 4 avec une connexion latérale 46, reliant les électrodes de masse ou de l'un des potentiels V$_1$ ou V$_2$ à la connexion 40 du condensateur, ainsi qu'une partie du système de pistes (51, 52, 53) de l'embase 1.

Selon cette première variante, la connexion électrique est faite à l'aide d'un bossage 47 réalisé sur la connexion 40 du condensateur, par exemple par dép*ot sérigraphique d'une couche de verre (non représentée) sur l'électrode 40 et la face inférieure du condensateur 4, sauf au niveau du bossage 47, puis d'une couche d'étain-plomb sur la partie laissée libre.

La figure 3b représente également le condensateur 4 et les connexions 51 à 53 de l'embase 1.

La connexion 46 du condensateur 4 est cette fois réalisée à l'intérieur d'un demi-trou 48, d'une façon analogue aux connexions 54 de l'embase 1 (figure 1). Dans cette variante, la connexion du condensateur 4 est réalisée par brasage (60) entre la connexion 53 de l'embase et la connexion 46 du condensateur.

La figure 3c représente également les connexions 51-53 de l'embase 1 et le condensateur 4. A la périphérie du condensateur 4 sont réalisés des passages, tels que 47, métallisés (48) sur leur périphérie, au droit des languettes 421, 431, 441 (figure 2b) des métallisations du condensateur 4. Le trou métallisé 47-48 est connecté à la connexion 53 par une soudure 61.

Le boîtier qui vient d'être décrit, comportant un condensateur placé au-dessus du composant et relié à l'embase, présente un certain nombre d'avantages, parmi lesquels, outre les caractéristiques déjà mentionnées, on peut citer:

- la faible longueur des connexions du condensateur au composant, ce qui permet de diminuer leur impédance;

- le fait que les points de distribution (tels que représentés à droite de 1a) figure 1a distribués à la périphérie du condensateur 4 constituent des connexions qu'il n'est éventuellement pas nécessaire de sortir du boîtier. En effet, le condensateur 4 est alimenté par l'extérieur (masse, V$_1$, V$_2$) en quelques points (premier mode de connexion), par exemple de 2 à 10 points pour un composant à 250 sorties, et il assure une fonction de répartition de l'énergie vers le composant 3 par de nombreuses connexions (de 50 à 100 dans l'exemple précédent) qui n'ont pas ainsi toutes à traverser le boîtier (deuxième mode de connexion);

- la facilité de mise en oeuvre technologique (choix des matériaux, conditions opératoires, vieillissement) due à la séparation des fonctions scellement/connexion du condensateur;

- la possibilité de test du composant et de son condensateur avant scellement du boîtier, ce qui permet la réparation.

La description faite ci-dessus l'a été à titre d'exemple non limitatif, et c'est ainsi que la plaquette 4 a été décrite comme comportant un condensateur réalisé par la technique multicouche (figure 2): la plaquette 4 peut, dans une variante de réalisation, être un substrat isolant portant un ou plusieurs condensateurs discrets; ces condensateurs, dans l'un ou l'autre des modes de réalisation (multicouche ou discret), sont susceptibles d'être utilisés aussi bien pour une fonction de découplage (quelques centaines de nanoFarad par exemple) que pour une fonction de réserve d'énergie (de l'ordre de 1F), par exemple; en outre, le condensateur multicouche a été représenté avec des couches parallèles à l'embase, mais celles-ci peuvent lui être perpendiculaires. Par ailleurs, une plaquette telle que 4 peut comporter d'autres composants actifs ou passifs à c*oté d'un ou plusieurs condensateurs, tels que inductances, résistances ou batteries de secours. Egalement, les connexions internes du condensateur 4, dans le cas où il s'agit d'un condensateur multicouche, ne sont pas obligatoirement réalisées à la périphérie du condensateur mais peuvent l'être en tout point. Enfin, on a représenté, figure 1, un boîtier du type chip-carrier à quatre étages, mais l'invention est applicable à tout type de boîtier classique, muni de broches de connexion ou non, avec un nombre quelconque d'étage, la seule condition étant d'éviter tout contact électrique entre la surface du composant, celle du condensateur et le capot, au moins lorsque celui-ci est métallique. Dans cet ordre d'idée, la présence de l'anneau 12 n'est pas indispensable; l'anneau 13 peut être remplacé par un anneau solidaire du condensateur 4 et l'anneau 14 par un anneau solidaire du capot 2.

**Revendications**

1. Boîtier de composant électronique comportant une embase (1) sur laquelle est fixé le composant (3) et un capot (2) fixé sur l'embase, caractérisé par le fait que le boîtier comporte en outre au moins un condensateur (4), placé entre le composant (3) et le capot (2), connecté électriquement à l'embase (1) et au composant.

2. Boîtier selon la revendication 1, caractérisé par le fait que le condensateur (4) est du type multicouches.

3. Boîtier selon la revendication 2, caractérisé par le fait qu'il comporte au moins deux condensateurs superposés, connectés à la masse et respectivement à au moins deux tensions distinctes (V$_1$, V$_2$).

4. Boîtier selon l'une des revendications 2 ou 3, caractérisé par le fait que chacune des armatures du condensateur présente une languette (421, 431, 441), s'étendant vers la périphérie du condensateur, de sorte que les languettes des armatures électriquement reliées soient les unes au-dessus des autres.

5. Boîtier selon la revendication 4, caractérisé par le fait que les languettes (421, 431, 441) sont reliées par des trous métallisés (47, 48).

6. Boîtier selon l'une des revendications précédentes, caractérisé par le fait que les connexions du condensateur (4) (47, 60, 61) sont placées à sa périphérie.

7. Boîtier selon l'une des revendications précédentes, caractérisé par le fait qu'une partie des connexions du condensateur (4) sont reliées au composant (3), sans sortir du boîtier.

8 Boîtier selon l'une des revendications précédentes, caractérisé par le fait que l'embase (1) comporte au moins une plaquette (11) et trois anneaux (12, 13, 14) concentriques, placés les uns au-dessus des autres sur la plaquette et autour du composant (3), de diamètre intérieur croissant, les connexions (50) du composant (3) étant reliées à des premières pistes conductrices (51) portées par le premier anneau (12), les connexions (40) du condensateur (4) étant reliées à des deuxièmes pistes conductrices (53) portés par le deuxième anneau (13), les premières ou deuxièmes pistes débouchant à l'extérieur du boîtier, des moyens de connexion (52) traversant le deuxième anneau pour relier les première et deuxième pistes conductrices, le capot (2) étant fixé sur le troisième anneau (14).

9. Boîtier selon l'une des revendications précédentes, caractérisé par le fait que le condensateur (4) est un condensateur de découplage.

10. Boîtier selon l'une des revendications précédentes, caractérisé par le fait que le condensateur (4) est une réserve d'énergie.

**Patentansprüche**

1. Gehäuse für ein elektronisches Bauteil mit einer Basis (1), auf der das Bauteil (3) befestigt ist, und einem Deckel (2), der auf der Basis befestigt ist, dadurch gekennzeichnet, daß das Gehäuse außerdem mindestens einen Kondensator (4) enthält, der zwischen dem Bauteil (3) und dem Deckel (2) liegt und elektrisch an die Basis (1) und an das Bauteil angeschlossen ist.

2. Gehäuse nach Anspruch 1, dadurch gekennzeichnet, daß der Kondensator (4) vom Vielschichtentyp ist.

3. Gehäuse nach Anspruch 2, dadurch gekennzeichnet, daß es mindestens zwei übereinanderliegende Kondensatoren aufweist, die an Masse und je an eine von mindestens zwei unterschiedlichen Spannungen $(V_1, V_2)$ angeschlossen sind.

4. Gehäuse nach einem der Ansprüche 2 oder 3, dadurch gekennzeichnet, daß jeder der Kondensatorbeläge eine Zunge (421, 431, 441) besitzt, die sich zur Peripherie des Kondensators hin erstreckt, so daß die Zungen der Beläge, die elektrisch miteinander verbunden sind, übereinanderliegen.

5. Gehäuse nach Anspruch 4, dadurch gekennzeichnet, daß die Zungen (421, 431, 441) durch metallisierte Löcher (47, 48) verbunden sind.

6. Gehäuse nach einem der vorhergehenden Ansprüche, dadurch gekennzeichnet, daß die Kondensatoranschlüsse (4) (47, 60, 61) an der Peripherie angeordnet sind.

7. Gehäuse nach einem der vorhergehenden Ansprüche, dadurch gekennzeichnet, daß einige Kondensatoranschlüsse (4) an das Bauteil (3) angeschlossen sind, ohne das Gehäuse zu verlassen.

8. Gehäuse nach einem der vorhergehenden Ansprüche, dadurch gekennzeichnet, daß die Basis (1) mindestens eine Platte (11) und drei konzentrische Ringe (12, 13, 14) aufweist, die übereinander auf der Platte liegen und das Bauteil (3) umgeben sowie zunehmenden Innendurchmesser besitzen, wobei die Anschlüsse (50) des Bauteils (3) an erste Leiterbahnen (51) auf dem ersten Ring (12), die Anschlüsse (40) des Kondensators (4) an zweite Leiterbahnen (53) auf dem zweiten Ring (13) angeschlossen sind und die ersten und zweiten Leiterbahnen aus dem Gehäuse herausführen, wobei Anschlußmittel (52) den zweiten Ring durchqueren, um die erste und die zweite Leiterbahn zu verbinden, und der Deckel (2) auf dem dritten Ring (14) befestigt ist.

9. Gehäuse nach einem der vorhergehenden Ansprüche, dadurch gekennzeichnet, daß der Kondensator (4) ein Entkopplungskondensator ist.

10. Gehäuse nach einem der vorhergehenden Ansprüche, dadurch gekennzeichnet, daß der Kondensator (4) ein Energiespeicher ist.

**Claims**

1. An electronic component casing comprising a base (1) on which the component (3) is fixed, and a cover (2) fixed to the base, characterized in that the casing further comprises at least one capacitor (4) located between the component (3) and the cover (2) and electrically connected to the base (1)

2. A casing according to claim 1, characterized in that the capacitor (4) is of the multilayer type.

3. A casing according to claim 2, characterized in that it comprises at least two stacked capacitors, connected to earth and respectively to at least two distinct voltages $(V_1, V_2)$.

4. A casing according to one of claims 2 or 3, characterized in that each one of the capacitor plates presents a reed (421, 431, 441) which extends to the periphery of the capacitor in such a way that the reeds of the plates which are electrically connected are disposed one above the others.

5. A casing according to claim 4, characterized in that the reeds (421, 431, 441) are connected via metallized holes (47, 48).

6. A casing according to one of the preceding claims, characterized in that the connections of the capacitors (4) (47, 60, 61) are located at its rim.

7. A casing according to one of the preceding claims, characterized in that some of the connections of the capacitor (4) are connected to the component (3) without leaving the casing.

8. A casing according to one of the preceding claims, characterized in that the base (1) comprises at least one plate (11) and three concentric rings (12, 13, 14) stacked one on the other on the plate and around the component (3), the rings having increasing inner diameters, the connections (50) of the component (3) being coupled to first conductor tracks (51) on the first ring (12), the connections (40) of the capacitor (4) being coupled to second conductor tracks (53) on the second ring (13), the first and second tracks extending to the outside of the casing, connection means (52) passing through the second ring in order to connect the first and second conductor tracks, the cover (2) being fixed to the third ring (14).

9. A casing according to one of the preceding claims, characterized in that the capacitor (4) is a decoupling capacitor.

10. A casing according to one of the preceding claims, characterized in that the capacitor (4) is an energy storing capacitor.

# FIG_1-a

# FIG_1-b

# FIG_2-a

# FIG_2-b

FIG_3-a

FIG_3-b

FIG_3-c